**Europäisches Patentamt**

**European Patent Office**

**Office européen des brevets**

(19)

(11) Veröffentlichungsnummer : **0 344 467 B1**

(12) **EUROPÄISCHE PATENTSCHRIFT**

(45) Veröffentlichungstag der Patentschrift :
**19.08.92 Patentblatt 92/34**

(51) Int. Cl.⁵ : **H03D 7/16, H03D 1/22**

(21) Anmeldenummer : **89107719.0**

(22) Anmeldetag : **28.04.89**

(54) **Quadratur-Empfänger.**

(30) Priorität : **04.05.88 DE 3815055**

(43) Veröffentlichungstag der Anmeldung :
**06.12.89 Patentblatt 89/49**

(45) Bekanntmachung des Hinweises auf die
Patenterteilung :
**19.08.92 Patentblatt 92/34**

(84) Benannte Vertragsstaaten :
**AT BE CH DE ES FR GB IT LI NL SE**

(56) Entgegenhaltungen :
**DE-A- 2 645 950**
**PHILIPS JOURNAL OF RESEARCH, Band 41,**
**Nr. 3, 1986, Seiten 219-231, Eindhoven, NL;**
**R.A. BROWN et al.: "Some features of signal-**
**demodulation resulting from the practical im-**
**plementation of a direct conversion radio**
**receiver"**

(73) Patentinhaber : **Standard Elektrik Lorenz**
**Aktiengesellschaft**
**Lorenzstrasse 10**
**W-7000 Stuttgart 40 (DE)**
(84) **DE**
Patentinhaber : **ALCATEL N.V.**
**Strawinskylaan 341 (World Trade Center)**
**NL-1077 XX Amsterdam (NL)**
(84) **BE CH ES FR GB IT LI NL SE AT**

(72) Erfinder : **Rother, Dietrich Dr.**
**Häldenstrasse 81**
**W-7146 Tamm (DE)**
Erfinder : **Ripka, Bernd, Dr.**
**Zeilenäckerstrasse 9**
**W-7533 Tiefenbronn-Mühlhausen (DE)**
Erfinder : **Berger, Rainer**
**Lochenweg 1**
**W-7470 Albstadt 2 (DE)**

(74) Vertreter : **Graf, Georg Hugo, Dipl.-Ing. et al**
**Standard Elektrik Lorenz AG Patent- und**
**Lizenzwesen Postfach 30 09 29**
**W-7000 Stuttgart 30 (DE)**

EP 0 344 467 B1

Jouve, 18, rue Saint-Denis, 75001 PARIS

**Beschreibung**

Die Erfindung bezieht sich auf einen Quadratur-Empfänger gemäß dem Oberbegriff des Anspruchs 1. Ein derartiger Empfänger ist beispielsweise aus der DE-PS 26 45 950 bekannt.

Bei der bekannten Umsetzung eines Empfangssignals in dessen Kophasal- und Quadraturkomponente können diese Komponenten aufgrund nichtidealer Mischereigenschaften verfälscht werden.

Aus "Philips Journal of Research", Vol.41, No.3, 1986, S.219-231, sind Verfahren bekannt, die speziell bei Null-ZF-Empfängern die durch Gleichstromdrift an den Ausgängen der Mischer auftretenden Verfälschungen kompensieren. Eines der Verfahren besteht darin, gleich große Gleichspannungen mit entgegengesetzten Vorzeichen an den Ausgängen zu überlagern. Dies ist jedoch schwierig, da sich die Gleichstromdrift dauernd ändert. Bei einem anderen Verfahren werden die Ausgänge der Mischer durch Wechselspannungskopplung mit den nachfolgenden Stufen verbunden. Dabei geht aber der zur inkohärenten Demodulation eines amplitudenmodulierten Empfangssignals notwendige Träger verloren. Bei einem frequenzmodulierten Empfangssignal werden Signalanteile in der Umgebung der Umsetzfrequenz unterdrückt.

Der Erfindung liegt die Aufgabe zugrunde, einen Quadratur-Empfänger mit einer Schaltung anzugeben, die durch nichtideale Eigenschaften, insbesondere der Mischer, hervorgerufene Verfälschungen der Quadratursignale kompensiert.

Die Lösung dieser Aufgabe erfolgt durch die im Hauptanspruch genannten Mittel. Vorteilhafte Weiterbildungen sind in den Unteransprüchen enthalten.

Die Erfindung wird nachstehend anhand mehrerer Ausführungsbeispiele erläutert. Es zeigen
Fig. 1 einen ersten Quadratur-Empfänger,
Fig. 2 einen Teil eines zweiten Quadratur-Empfängers,
Fig. 3 einen Teil eines Quadratur-Empfängers, der nach dem Weaver-Verfahren arbeitet.

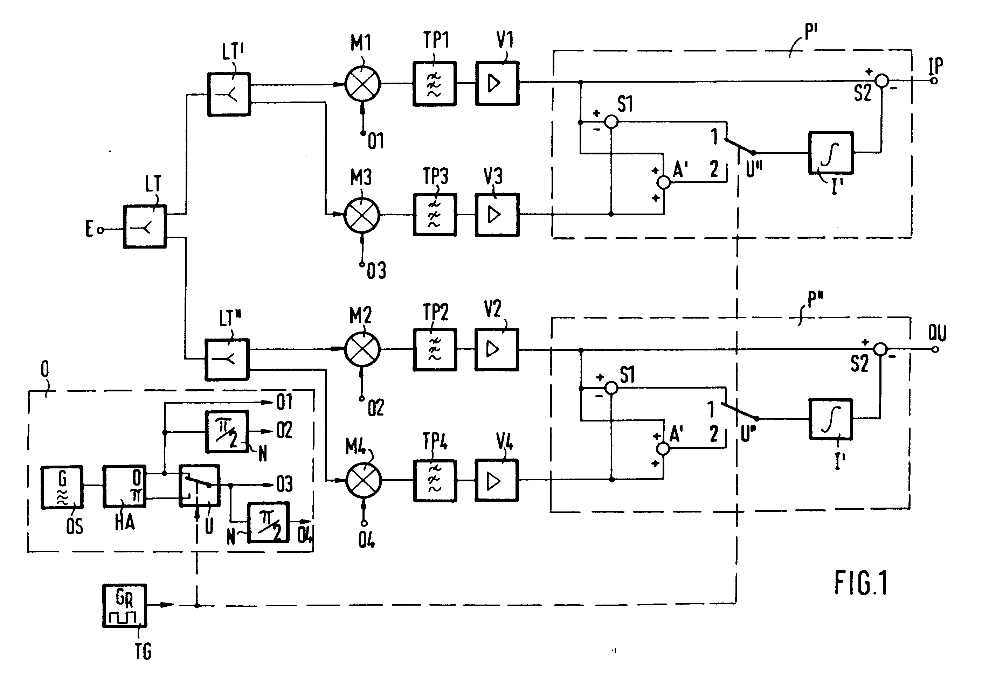

Der Quadratur-Empfänger nach Fig. 1 weist drei in Baumstruktur hintereinandergeschaltete Leistungsteiler LT, LT', LT'' auf, die ein Empfangssignal E in vier Teilsignale aufspalten. Dem Leistungsteiler LT' ist ein erster und ein dritter Mischer M1, M3 und dem Leistungsteiler LT'' ein zweiter und ein vierter Mischer nachgeschaltet. Dem ersten Mischer M1 ist ein erstes Tiefpaßfilter TP1 und diesem ein erster Verstärker V1 nachgeschaltet. Entsprechend sind dem zweiten, dritten und vierten Mischer M2, M3, M4 je ein Tiefpaßfilter TP2, TP3, TP4 und Verstärker V2, V3, V4 nachgeschaltet. Der Ausgang des ersten Verstärkers V1 ist mit dem ersten Eingang und der Ausgang des dritten Verstärkers V3 mit dem zweiten Eingang einer ersten Schaltung P' verbunden, die an ihrem Ausgang ein In-Phase-Signal IP abgibt. Der Ausgang des zweiten Verstärkers V2 ist mit dem ersten Eingang und der Ausgang des vierten Verstärkers V4 mit dem zweiten Eingang einer zweiten Schaltung P'' verbunden, die an ihrem Ausgang ein Quadratursignal QU abgibt. Die erste und zweite Schaltung P', P'' sind baugleich.

Jede Schaltung P', P'' enthält einen Addierer A', zwei Subtrahierer S1, S2, einen Umschalter U'' und einen Integrierer I'. Der Addierer A' addiert die beiden Eingangssignale der Schaltung, der erste Subtrahierer S1 subtrahiert vom am ersten Eingang anliegenden Eingangssignal das am zweiten Eingang anliegende. Der Umschalter U'' führt abwechselnd entweder das Ausgangssignal des Addierers A' oder das Ausgangssignal des ersten Subtrahierers S1 dem Integrierer I' zu, dessen Ausgangssignal durch den zweiten Subtrahierer S2 vom am ersten Eingang der Schaltung P', P'' anliegenden Eingangssignal abgezogen wird. Das Ausgangssignal des zweiten Subtrahierers S2 ist das Ausgangssignal der Schaltung P', P''.

Der Quadratur-Empfänger enthält ferner eine Oszillatorschaltung O, die vier Oszillatorsignale O1, O2, O3, O4 erzeugt. Das erste Oszillatorsignal O1 ist dem ersten Mischer M1 zugeführt. Das zweite Oszillatorsignal O2 ist gegenüber dem ersten um 90° phasenverschoben und dem zweiten Mischer M2 zugeführt.

Das dritte Oszillatorsignal O3 weist abwechselnd die gleiche oder entgegengesetzte Phase auf wie das erste und ist dem dritten Mischer M3 zugeführt. Das vierte Oszillatorsignal O4 weist abwechselnd die gleiche oder entgegengesetzte Phase auf wie das zweite und ist dem vierten Mischer M4 zugeführt.

Die Oszillatorschaltung O enthält einen Oszillator OS, dem eine Schaltung HA nachgeschaltet ist, die das Signal des Oszillators OS in zwei um 180° gegeneinander phasenverschobene Signale aufteilt. Das erste Oszillatorsignal O1 ist direkt am einen Ausgang der Schaltung HA abgreifbar, das zweite Oszillatorsignal O2 ist aus dem ersten durch Phasendrehung mittels eines 90°-Phasendrehgliedes N erzeugt. Die Oszillatorschaltung O enthält ferner einen Umschalter U, an dessen Ausgang das dritte Oszillatorsignal O3 auftritt, indem er abwechselnd den einen oder den anderen Ausgang der Schaltung HA mit seinem Ausgang verbindet. Das vierte Oszillatorsignal O4 ist aus dem dritten durch Phasendrehung mittels eines weiteren 90°-Phasendrehgliedes N erzeugt.

Der Quadratur-Empfänger weist außerdem einen Taktgenerator TG auf, der den Umschalter U in der Oszillatorschaltung O und die Umschalter U'' in den Schaltungen P', P'' so steuert, daß diese synchron zueinander umschalten. Diese Umschaltung erfolgt vorzugsweise mit einer Frequenz von einigen kHz.

Die Kompensation der Gleichstromdrift an den Ausgängen der Mischer M1-M4 und auch der zusätzlichen Gleichstromdrift, die durch die den Mischern M1-M4 nachgeschalteten Verstärker V1-V4 hervorgerufen ist, mit Hilfe der Schaltungen P', P'' wird durch den Umstand ermöglicht, daß die Gleichstromdrift von der Phasenlage der Oszillatorsignale O1-O4 unabhängig, das umgesetzte Empfangssignal jedoch davon abhängig ist. Man erhält also einen Vorzeichenwechsel des vom Empfangssignal stammenden Anteils im Mischprodukt, wenn die Phase der Oszillatorsignale O3, O4 zwischen 0° und 180° umgeschaltet wird.

Bezeichnet man den Anteil der Gleichstromdrift im (verstärkten) Mischprodukt des ersten (oder zweiten) Mischers M1 (oder M2) mit G' und den Anteil der Gleichstromdrift im (verstärkten) Mischprodukt des dritten (oder vierten) Mischers M3 (oder M4) mit G'', so tritt am Ausgang des ersten Subtrahierers S1 bei der in Fig. 1 gezeichneten Stellung der Umschalter U, U'' die Größe G'-G'' auf, die dem Integrierer I' zugeführt wird. Nach dem Umschalten tritt am Ausgang des Addierers A die Größe G'+G'' auf, die dem Integrierer I' zugeführt wird. Über einen Umschaltzyklus gemittelt liefert daher der Integrierer I' an seinem Ausgang genau die Größe G', die mittels des zweiten Subtrahierers S2 von dem vom ersten (oder zweiten) Mischer M1 (oder M2) stammenden Signal subtrahiert wird, das dadurch von seiner Gleichstromdrift G' befreit wird.

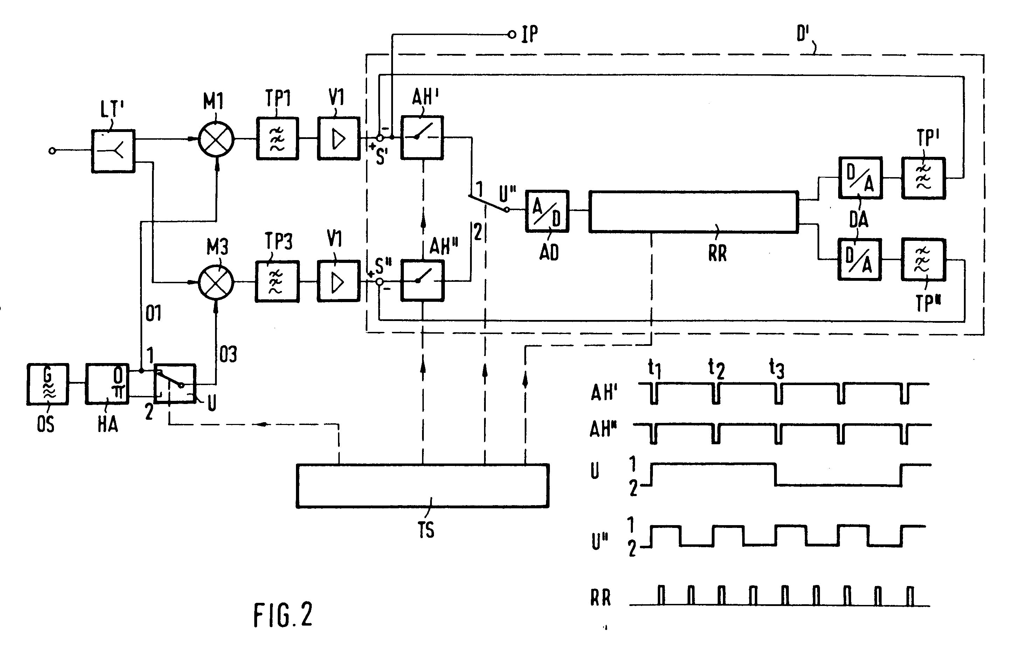

Fig. 2 zeigt einen Teil eines zweiten Quadratur-Empfängers, der sich von dem nach Fig. 1 dadurch unterscheidet, daß er statt den Schaltungen P', P'' digitale Schaltungen D', D'' mit Reglern und statt des Taktgenerators TG eine Taktsteuerung TS aufweist. Aus Gründen der Übersichtlichkeit wurde auf die Darstellung des restlichen Teils des zweiten Quadratur-Empfängers verzichtet, der die mit der ersten digitalen Schaltung D' baugleiche, zweite digitale Schaltung D'' enthält.

Die digitale Schaltung D' weist an jedem Eingang einen Subtrahierer S', S'' auf, dem ein Abtast-Halte-Glied AH', AH'' nachgeschaltet ist. Der Umschalter U'' führt abwechselnd entweder das Ausgangssignal des einen oder des anderen Abtast-Halte-Glieds AH', AH'' einem A/D-Wandler AD zu, dem ein Rechenwerk RR und diesem zwei D/A-Wandler DA nachgeschaltet sind. Jedem D/A-Wandler DA ist je ein Tiefpaßfilter TP', TP'' nachgeschaltet, deren Ausgangssignale den invertierenden Eingängen der Subtrahierer S', S'' zugeführt sind. Am Ausgang des dem ersten Eingang nachgeschalteten Subtrahierers S' ist das Ausgangssignal der Schaltung D' abgreifbar.

Wie aus der vorstehenden Beschreibung und Fig. 2 entnehmbar, enthält die digitale Schaltung D' zwei Regelkreise. Die Regelgrößen sind die Gleichstromdriften G' und G'', die durch das Rechenwerk RR berechnet werden- und durch je einen im Rechenwerk RR enthaltenen Regler auf Null geregelt werden. Die Ausgänge der Regler sind mit den D/A-Wandlern DA verbunden. Die für die Regelungen notwendigen Führungsgrößen werden im Rechenwerk RR erzeugt. Die Regler weisen PI-Verhalten auf; wegen der langsamen zeitlichen Änderung der Regelgrößen ist ein D-Verhalten der Regler nicht erforderlich.

Die Taktsteuerung TS steuert nicht nur den Umschalter U in der Oszillatorschaltung und den Umschalter U'' in den digitalen Schaltungen D', D'' sondern auch die Abtast-Halte-Glieder AH', AH'' und das Rechenwerk RR. Ein Taktdiagramm ist ebenfalls in Fig. 2 dargestellt.

Durch die Abtast-Halte-Glieder AH', AH'' werden zu den Zeitpunkten $t_1$, $t_2$,... die Eingangsspannungen abgetastet und bis zum nächsten Abtastzeitpunkt zwischengespeichert. Durch fortlaufendes Umschalten des Umschalters U'' werden diese Abtastwerte nach Analog-/Digitalwandlung dem Rechenwerk RR zugeführt. Im Taktdiagramm ist der Fall dargestellt, daß nach jedem Umschalten je zwei Abtastwerte ins Rechenwerk RR eingelesen und dort gemittelt werden.

Im Vergleich zu den Schaltungen P', P'' des ersten Ausführungsbeispiels gemäß Fig. 1, die keinen Regler enthalten, werden bei den digitalen Schaltungen D', D'' mit Hilfe der Regler auch Linearitätsfehler der Schaltungen und Abweichungen im Verstärkungsfaktor vom idealen Wert 1 kompensiert. Die Einschwingzeit der Regelkreise ist bei Kompensation der Gleichstromdriften G', G'' beider Mischer kleiner, als wenn nur ein Regelkreis zur Kompensation der Gleichstromdrift G' vorhanden ist. Andere Ausführungen der Schaltungen P', P'' mit einem derartigen Regelkreis enthalten zusätzlich ein dem Integrierer I' nachgeschalteten Regler, wobei dem Addierer A' und dem ersten Subtrahierer S1 das Ausgangssignal des zweiten Subtrahierers S2 anstelle des am ersten Eingang anliegenden Signals zugeführt ist.

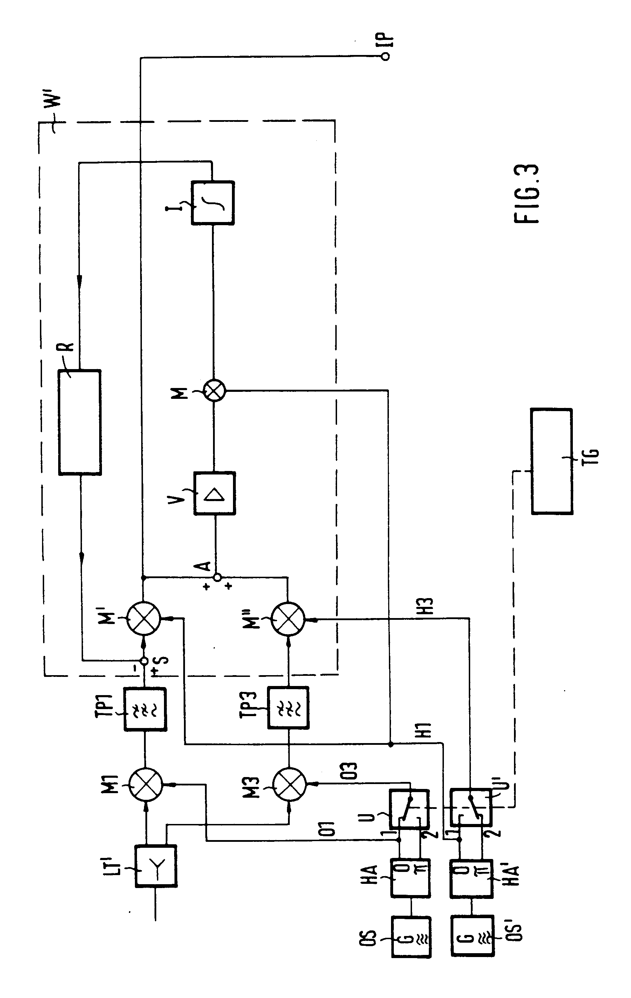

Fig. 3 zeigt einen Teil eines dritten Quadratur-Empfängers, der nach dem Weaver-Verfahren arbeitet und der sich von dem nach Fig. 1 durch die Schaltungen W', W'' unterscheidet, wobei wie in Fig. 2 aus Gründen der Übersichtlichkeit auf die Darstellung des restlichen Teils mit der Schaltung W'' verzichtet ist, die mit der Schaltung W' baugleich ist. Zusätzlich zur Oszillatorschaltung O weist der dritte Quadratur-Empfänger eine mit dieser baugleiche zusätzliche Oszillatorschaltung auf, von der ebenfalls nur ein Teil dargestellt ist und die vier Hilfssignale H1-H4 erzeugt. Der Taktgenerator TG steuert die Umschalter U, U' in den Oszillatorschaltungen derart, daß sie gleichzeitig, aber gegenphasig umschalten.

Die Schaltung W' weist an ihrem ersten Eingang einen Subtrahierer S und an ihrem zweiten Eingang einen weiteren Mischer M'' auf. Dem Subtrahierer S ist ein anderer Mischer M' nachgeschaltet, dessen Ausgangssignal das Ausgangssignal der Schaltung W' ist. Die Ausgangssignale der Mischer M', M'' sind einem Addierer

3

A zugeführt, dem ein Verstärker V und diesem ein zusätzlicher Mischer M nachgeschaltet sind. Dem zusätzlichen Mischer M und dem anderen Mischer M′ ist das erste Hilfssignal H1 und dem weiteren Mischer M″ das dritte Hilfssignal H3 zugeführt, das abwechselnd die gleiche oder entgegengesetzte Phase aufweist wie das erste. Dem zusätzlichen Mischer M ist ein Integrierer I und diesem ein Regler R nachgeschaltet, dessen Ausgangssignal dem invertierenden Eingang des Subtrahierers S zugeführt ist.

**Patentansprüche**

1. Empfänger mit einem Oszillator und mindestens einem ersten und einem zweiten Mischer (M1, M2), die ein Empfangssignal mit einem ersten und zweiten Oszillatorsignal (O1, O2) mischen, deren Phasen gegeneinander um 90° verschoben sind,
**dadurch gekennzeichnet,** daß er ferner einen dritten und vierten Mischer (M3, M4) enthält, die das Empfangssignal mit einem dritten und vierten Oszillatorsignal (O3, O4) mischen, wobei das dritte bezüglich des ersten und das vierte bezüglich des zweiten Oszillatorsignals alternierend die gleiche oder entgegengesetzte Phase aufweisen, daß er eine erste Schaltung (P′, D′, W′) enthält, die zwei Eingänge aufweist, wobei der erste Eingang dem ersten und der zweite Eingang dem dritten Mischer nachgeschaltet ist und die an ihrem Ausgang ein In-Phase-Signal abgibt, und daß er eine zweite Schaltung (P″, D″, W″) enthält, die zwei Eingänge aufweist, wobei der erste Eingang dem zweiten und der zweite Eingang dem vierten Mischer nachgeschaltet ist und die an ihrem Ausgang ein Quadratur-Signal abgibt.

2. Empfänger nach Anspruch 1, dadurch gekennzeichnet, daß die erste Schaltung (P′, D′, W′) und die zweite Schaltung (P″, D″, W″) baugleich sind und daß zwischen die Mischer (M1-M4) und die Schaltungen (P′, D′, W′, P″, D″, W″) je ein Tiefpaßfilter (TP1-TP4) geschaltet ist.

3. Empfänger nach Anspruch 1 oder 2, dadurch gekennzeichnet, daß die Mischer (M1-M4) das Eingangssignal auf eine Zwischenfrequenz Null umsetzen.

4. Empfänger nach Anspruch 1, 2 oder 3, dadurch gekennzeichnet, daß jede Schaltung (P′, P″) einen Addierer (A′), zwei Subtrahierer (S1, S2), einen Umschalter (U″) und einen Integrierer (I′) enthält, daß der Addierer (A′) die am ersten und zweiten Eingang anliegenden Signale addiert, daß der erste Subtrahierer (S1) vom am ersten Eingang anliegenden Signal das am zweiten Eingang anliegende Signal subtrahiert, daß entweder das Ausgangssignal des Addierers (A′) oder das des ersten Subtrahierers (S1) über den Umschalter (U″) dem Integrierer (I′) zugeführt sind, wobei der Umschalter (U″) synchron zu den Phasensprüngen des in der Phase alternierenden Oszillatorsignals umschaltet, und daß das Ausgangssignal des Integrierers (I′) vom am ersten Eingang anliegenden Signal durch den zweiten Subtrahierer (S2) subtrahiert ist, wodurch das Ausgangssignal der Schaltung (P′, P″) entsteht.

5. Empfänger nach Anspruch 4, dadurch gekennzeichnet, daß jede Schaltung (P′, P″) einen dem Integrierer (I′) nachgeschalteten Regler (R) enthält und daß dem Addierer (A′) und dem ersten Subtrahierer (S1) das Ausgangssignal des zweiten Subtrahierers (S2) anstelle des am ersten Eingang anliegenden Signals zugeführt ist.

6. Empfänger nach Anspruch 1, 2 oder 3, dadurch gekennzeichnet, daß bei Null-ZF-Empfängern zur Kompensation der Gleichstromdrift in den von den Mischern gelieferten Signalen die Schaltung (D′, D″) an ihren beiden Eingängen je einen Subtrahierer (S) aufweist, denen ein Rechenwerk (RR) zur Berechnung von Kompensationssignalen nachgeschaltet ist, die den invertierenden Eingängen der Subtrahierer (S) zugeführt sind, und daß am Ausgang des dem ersten Eingang nachgeschalteten Subtrahierers das Ausgangssignal der Schaltung (D′, D″) abgreifbar ist.

7. Empfänger nach Anspruch 6, dadurch gekennzeichnet, daß dem Rechenwerk (RR) mindestens ein A/D-Wandler (AD) vor- und zwei D/A-Wandler (DA) nachgeschaltet sind.

8. Empfänger nach Anspruch 2, dadurch gekennzeichnet, daß das Empfangssignal durch die Oszillatorsignale (O1-O4) auf eine tiefe, von Null verschiedene Zwischenfrequenz umgesetzt ist, daß jede Schaltung (W′, W″) an ihrem zweiten Eingang einen weiteren Mischer (M″) und an ihrem ersten Eingang einen Subtrahierer (S) aufweist, dem ein anderer Mischer (M′) nachgeschaltet ist, die ihre Eingangssignale mittels zweier Hilfssignale auf eine hohe Zwischenfrequenz umsetzen, wobei das Hilfssignal, das dem weiteren Mischer (M″) zugeführt ist, alternierend die gleiche oder entgegengesetzte Phase aufweist wie das andere Hilfssignal, und die Phasen der Hilfssignale in den beiden Schaltungen (W′, W″) gegeneinander um 90° verschoben sind, daß den Mischern (M′, M″) ein Addierer (A), diesem ein zusätzlicher Mischer (M) und diesem ein Integrierer (I) nachgeschaltet ist, dessen Signal über einen Regler (R) dem invertierenden Eingang des Subtrahierers (S) zugeführt ist, daß der zusätzliche Mischer (M) das Signal des Addierers (A) mittels des anderen Hilfssignals auf die tiefe Zwischenfrequenz umsetzt und daß am Ausgang des anderen Mischers (M′) das Ausgangssignal der Schaltung (W′, W″) abgreifbar ist.

**Claims**

1. Receiver comprising an oscillator and at least a first mixer (M1) and a second mixer (M2) which mix a received signal with a first oscillator signal (O1) and a second oscillator signal (O2), respectively, which differ in phase by 90°,
**characterized in that** the receiver further includes a third mixer (M3) and a fourth mixer (M4) which mix the received signal with a third oscillator signal (O3) and a fourth oscillator signal (O4), respectively, with the third oscillator signal being alternately in phase with and in phase opposition to the first oscillator signal, and the fourth oscillator signal being alternately in phase with and in phase opposition to the second oscillator signal, that the receiver contains a first circuit (P', D', W') which has two inputs the first of which follows the first mixer and the second of which follows the third mixer, and which provides an in-phase signal at its output, and that the receiver contains a second circuit (P", D", W") which has two inputs the first of which follows the second mixer and the second of which follows the fourth mixer, and which provides a quadrature signal at its output.

2. A receiver as claimed in claim 1, characterized in that the first circuit (P', D', W') and the second circuit (P", D", W") are identical in construction, and that a low-pass filter (TP1-TP4) is connected between each of the mixers (M1-M4) and the associated circuits (P', D', W', P", D", W").

3. A receiver as claimed in claim 1 or 2, characterized in that the mixers (M1-M4) convert the input signal to a zero IF.

4. A receiver as claimed in claim 1, 2, or 3, characterized in that each circuit (P', P") contains an adder (A'), two subtracters (S1, S2), a changeover switch (U"), and an integrator (I'), that the adder (A') adds the signals applied to the first and second inputs, that the first subtracter (S1) subtracts the signal applied to the second input from the signal applied to the first input, that either the output of the adder (A') or that of the first subtracter (S1) is applied via the changeover switch (U") to the integrator (I'), with the changeover switch (U") being operated synchronously with the phase reversals of the phase-alternating oscillator signal, and that the output signal of the integrator (I') is subtracted by the second subtracter (S2) from the signal applied to the first input to obtain the output signal of the circuit (P', P").

5. A receiver as claimed in claim 4, characterized in that each circuit (P', P") contains a controller (R) following the integrator (I'), and that instead of the signal applied at the first input, the output of the second subtractor (S2) is applied to the adder (A') and the first subtractor (S1).

6. A receiver as claimed in claim 1, 2, or 3, characterized in that in zero-IF receivers, in order to compensate for the DC offset in the signals provided by the mixers, the circuit (D', D") has a subtracter (S) at each of its two inputs which subtracters are followed by an arithmetic unit (RR) for computing compensation signals which are applied to the inverting inputs of the subtracters (S), and that the output signal of the circuit (D', D") is obtainable from the output of the subtracter behind the first input.

7. A receiver as claimed in claim 6, characterized in that the arithmetic unit (RR) is preceded by at least one A/D converter (AD) and followed by two D/A converters (DA).

8. A receiver as claimed in claim 2, characterized in that the received signal is converted by the oscillator signals (O1-O4) to a low IF different from zero, that each circuit (W', W") has a further mixer (M") at its second input and a subtracter (S) followed by another mixer (M') at its first input which convert their input signals to a high IF by means of two auxiliary signals, with the auxiliary signal for the further mixer (M") being alternately in phase with and in phase opposition to the other auxiliary signal, and the phases of the auxiliary signals in the two circuits (W', W") separated by 90°, that the other mixer (M') and the further mixer (M") are followed by an adder (A) having its output connected to an additional mixer (M) followed by an integrator (I) whose output is fed through a controller (R) to the inverting input of the subtracter (S), that the additional mixer (M) converts the signal from the adder (A) to the low IF by means of the other auxiliary signal, and that the output signal of the circuit (W', W") is obtainable from the output of the other mixer (M').

**Revendications**

1. Récepteur comportant un oscillateur et au moins un premier et un second mélangeurs (M1, M2) qui mélangent un signal de réception avec un premier et un second signaux d'oscillateur (O1, O2) dont les phases sont décalées de 90° l'une par rapport à l'autre, récepteur
**caractérisé par le fait** qu'il contient en outre un troisième et un quatrième mélangeurs (M3, M4) qui mélangent le signal de réception avec un troisième et un quatrième signaux d'oscillateur (O3, O4), étant précisé que le troisième, par rapport au premier, et le quatrième, par rapport au second signal d'oscillateur, présentent alternativement la même phase ou la phase opposée; par le fait qu'il contient un premier circuit (P', D', W') qui présente deux entrées, la première entrée étant située en aval du premier mélangeur et la seconde entrée en aval

5

du troisième mélangeur, et qui donne à sa sortie un signal en phase; et par le fait qu'il contient un second circuit (P″, D″, W″) qui présente deux entrées, la première entrée étant située en aval du second mélangeur et la deuxième entrée en aval du quatrième mélangeur, et qui donne à sa sortie un signal en quadrature.

2. Récepteur selon la revendication 1, caractérisé par le fait que le premier circuit (P′, D′, W′) et le second circuit (P″, D″, W″) sont identiques et par le fait qu'entre les mélangeurs (M1-M4) et les circuits (P′, D′, W′, P″, D″, W″) est chaque fois mis en circuit un filtre passe-bas (TPA-TP4).

3. Récepteur selon la revendication 1 ou 2, caractérisé par le fait que les mélangeurs (M1-M4) convertissent le signal d'entrée sur une fréquence intermédiaire nulle.

4. Récepteur selon la revendication 1, 2 ou 3, caractérisé par le fait que chaque circuit (P′, P″) contient un additionneur (A′), deux soustracteurs (S1, S2), un commutateur (U″) et un intégrateur (I′); par le fait que l'additionneur (A′) additionne les signaux qui se trouvent à la première et à la seconde entrées; par le fait que le premier soustracteur (S1) soustrait, du signal qui se trouve à la première entrée, le signal qui se trouve à la seconde entrée; par le fait que l'on envoie à l'intégrateur (I′), par l'intermédiaire du commutateur (U″), soit le signal de sortie de l'additionneur (A′), soit celui du premier soustracteur (S1), étant précisé que le commutateur (U″) commute en synchronisme avec les sauts de phase du signal d'oscillateur qui alterne en phase; et par le fait que le signal de sortie de l'intégrateur (I′) est soustrait, par le second soustracteur (S2), du signal qui se trouve à la première entrée, ce qui donne le signal de sortie du circuit (P′, P″).

5. Récepteur selon la revendication 4, caractérisé par le fait que chaque circuit (P′, P″) contient un régulateur (R) mis en circuit en aval de l'intégrateur (I′) et par le fait qu'à l'additionneur (A′) et au premier soustracteur (S1), au lieu du signal qui se trouve à la première entrée, on envoie le signal de sortie du second soustracteur (S2).

6. Récepteur selon la revendication 1, 2 ou 3, caractérisé par le fait que dans le cas des récepteurs à fréquence intermédiaire nulle, pour compenser la dérive du courant continu dans les signaux fournis par les mélangeurs, le circuit (D′, D″) présente à chacune de ses deux entrées un soustracteur (S° en aval duquel est mis en circuit un calculateur (RR) pour le calcul de signaux de compensation qui sont envoyés aux entrées de changement de signe des soustracteurs (S); et par le fait qu'à la sortie du soustracteur mis en circuit en aval de la première entrée on peut prélever le signal de sortie du circuit (D′, D″).

7. Récepteur selon la revendication 6, caractérisé par le fait qu'en amont du calculateur (RR) est mis en circuit au moins un transducteur analogique-numérique (AD) et, en aval, deux transducteurs numériques-analogiques (DA).

8. Récepteur selon la revendication 2, caractérisé par le fait que le signal de sortie est converti, par les signaux d'oscillateur (O1-O4), sur une fréquence intermédiaire basse, différente de zéro; par le fait que chaque circuit (W′, W″) présente à sa seconde entrée un autre mélangeur (M″) et à sa première entrée un soustracteur (R) en aval duquel est mis en circuit un autre mélangeur (M′), mélangeurs qui convertissent leurs signaux de sortie sur une fréquence intermédiaire élevée au moyen de deux singaux auxiliaires, étant précisé que le signal auxiliaire qui est amené à l'autre mélangeur (M″) présente alternativement la même phase que celle de l'autre signal auxiliaire, ou la phase opposée, et que les phases des signaux auxiliaires dans les deux circuits (W′, W″) sont décalées l'une par rapport à l'autre de 90°; par le fait qu'en aval des mélangeurs (M′, M″) est mis en circuit un additionneur (A), en aval de celui-ci, un mélangeur supplémentaire (M), et en aval de celui-ci un intégrateur (I) dont le signal est envoyé, par l'intermédiaire d'un régulateur (R), à l'entrée de changement de signe du soustracteur (S); par le fait que le mélangeur supplémentaire (M) convertit le signal de l'additionneur (A) sur la fréquence intermédiaire basse au moyen de l'autre signal auxiliaire et par -le fait qu'à la sortie de l'autre mélangeur (M′) on peut prélever le signal de sortie du circuit (W′, W″).

FIG.1

EP 0 344 467 B1

FIG.2

FIG.3